# EUROPEAN PATENT APPLICATION

(11) **EP 4 415 491 A1**
(43) Date of publication of application: **14.08.2024**
(21) Application number: 24154121.8
(22) Date of filing: 26.01.2024
(51) Int. Cl.: H05K 5/00

(54) **ELECTRONIC CONTROL UNIT**

(30) Priority: 10.02.2023 CN 202310108001
(71) Applicant: Robert Bosch GmbH, 70442 Stuttgart (DE)
(72) Inventor: LIU, Xiaoqian, Jiangsu, 215021 (CN); JIANG, Bernie, Jiangsu, 215021 (CN)

(57) **Abstract**

The present disclosure relates to an electronic control unit, comprising a base plate, wherein comprises a load-bearing area and a mounting area provided on a side of the load-bearing area, with at least one guide hole penetrating the base plate provided in the mounting area; a housing mounted on the load-bearing area of the base plate, wherein comprises a top wall and side walls extending downward from the edge of the top wall and continuously disposed around the top wall, with the top wall and the side walls collectively defining the accommodating space of the housing; a printed circuit board housed in the accommodating space between the base plate and the housing; and an electrical connector electrically connected to the printed circuit board, which is exposed through an opening provided on one of the side walls and is positioned above the guide holes. The electronic control unit of the present disclosure has enhanced waterproof capabilities that are capable of effectively preventing water from entering the interior of the electronic control unit, thereby improving the service life and operating precision of the electronic control unit.

## Description

### Technical Field

The present disclosure relates to the field of vehicle electronics technology, in particular to an electronics control unit for vehicles, and more particularly to an electronics control unit for airbags that effectively improves waterproof performance.

### Background Art

Electronic control units (ECUs) are generally designed in an open manner in the field of vehicles. In other words, there are gaps between the housing of the ECU and the electrical connector, and between the base plate and the electrical connector. When the ECU is tilted at a particular angle, water flow may enter through the above gaps. If the water flow enters the interior of the ECU, the printed circuit board will be affected, causing the ECU to fail.

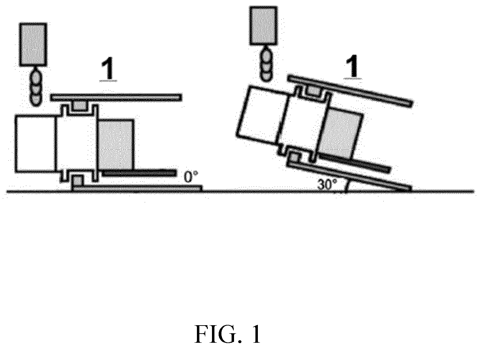

Taking as an example the common airbag ECU in the field of vehicles, which is usually installed under the handbrake part of the vehicle, it receives signals on overall vehicle status from the vehicle controller and at the same time detects collision signals. In the event of a traffic accident, it issues a signal to deploy the safety airbags, ensuring the safety of the vehicle occupants. Given the special installation position of the airbag ECU, compared to other commonly used ECUs, when the vehicle is inclined at a certain slope, liquid (such as water or juice, etc.) contained in a cup holder is more prone to splash onto the area where the safety airbag ECU is located. Thus, for such ECUs, more stringent waterproof testing standards than ISO certification are required. For instance, in the IPX52 waterproof test simulating water or juice splashes on the ECU 1 when the vehicle is inclined on a steep slope (10 - 30 degrees) (see FIG. 1), the unit needs to effectively drain accumulated water within 4.5 minutes when exposed to approximately 350 milliliters of liquid splashed from a height of 3 centimeters from above to ensure the normal operation of the ECU. The above standards are more difficult to meet for some ECUs with specific mounting hole requirements on the base plate (e.g., the base plate length is greater than the length of the electrical connector area). On the other hand, conventional solutions of reinforcing sealing imply additional materials, processes, and cycle times, thereby resulting in increased costs.

It should be noted that the "Background Art" section is merely intended to facilitate understanding of the content of the present disclosure, and therefore, the content disclosed in the "Background Art" section may include some prior art that is not necessarily known to those skilled in the art. The content disclosed in the "Background Art" section does not necessarily represent the problems that this content or one or more examples of the present disclosure are intended to address, and it may have been known or recognized by those skilled in the art before the filing of the present disclosure.

### Summary of Invention

The purpose of the present disclosure is to overcome the deficiencies in the above prior art and provide an ECU for vehicles with enhanced waterproof capabilities. The ECU has enhanced waterproof capabilities that are capable of effectively preventing water from entering the interior of the electronic control unit, thereby improving the service life and operating precision of the ECU.

To achieve the above purpose, an ECU is provided, comprising a base plate, wherein comprises a load-bearing area and a mounting area provided on a side of the load-bearing area, with at least one guide hole penetrating the base plate provided in the mounting area; a housing mounted on the load-bearing area of the base plate, wherein comprises a top wall and side walls extending downward from the edge of the top wall and continuously disposed around the top wall, with the top wall and the side walls collectively defining the accommodating space of the housing; a printed circuit board housed in the accommodating space between the base plate and the housing; and an electrical connector electrically connected to the printed circuit board, which is exposed through an opening provided on one of the side walls and is positioned above the guide holes.

Preferably, the base plate is an integral stamped piece made of a metal material, and the load-bearing area is provided with a rib configured to enclose the load-bearing area and protrude towards the printed circuit board in a plane perpendicular to the load-bearing area.

Preferably, the inner peripheral profile of the lower portion of the side walls matches the outer peripheral profile of the rib, such that the side walls of the housing encloses the rib in a clearance-fitting manner in the assembled state.

Preferably, the load-bearing area further comprises a plurality of mounting bosses provided in the area enclosed by the rib and protruding in the same protrusion direction as the rib, such that a gap is created between the printed circuit board and the base plate in the assembled state.

Preferably, a part of the rib positioned between the electrical connector and the base plate is raised as compared to other parts of the rib, such that viewing that part of the rib in the direction in which the opening is opened obscures the gap between the printed circuit board and the base plate.

Preferably, mounting holes are provided at the top of each mounting boss, and with the aid of fasteners passing through the mounting holes and through corresponding mounting holes provided in the housing and in the printed circuit board, the base plate, the housing and the printed circuit board are secured together, wherein a reinforcing element is provided between the mounting bosses in the load-bearing area, of which the reinforcing element protrudes in the same protrusion direction as the mounting bosses and has a protrusion height smaller than the protrusion height of the mounting bosses.

Preferably, in the assembled state the housing has a protruding eave that covers the electrical connector, as well as a first shielding portion and a second shielding portion, with the protruding eave connecting the first shielding portion and the second shielding portion; on the side of the mounting area distal from the electrical connector, a first protruding edge is provided extending transversely to the direction in which the opening is opened; the guide holes are positioned between the rib and the first protruding edge in the direction in which the opening is opened; the distance of the first protruding edge extending transversely corresponds to the length of the electrical connector in the direction transverse to the direction in which the opening is opened, with the distance being greater than the distance between the two furthest guide holes from each other; additionally, in the assembled state, the protruding eave, the first shielding portion and the second shielding portion, along with the mounting area on the side of the base plate where guide holes are provided, collectively enclose the electrical connector exposed from the opening.

Preferably, the first shielding portion and the second shielding portion extend in the direction in which the opening is opened until the first protruding edge is enclosed in the direction transverse to the direction in which the opening is opened.

Preferably, the mounting area further comprises: a plurality of positioning recesses, a bracket mounting hole provided at the bottom of each positioning recess, and a second protruding edge, which extends in the direction transverse to the direction in which the opening is opened on the side of the mounting area distal from the electrical connector, and the plurality of positioning recesses extend separately from the first protruding edge and the second protruding edge towards the edges or corners of the corresponding mounting area.

Preferably, a positioning recess extends transversely, on the side of the mounting area proximate to the electrical connector, from the first protruding edge to the corner of the mounting area, and two positioning recesses extend separately, on the side of the mounting area distal from the electrical connector, from the second protruding edge to the two corners of the mounting area.

Preferably, the guide holes are configured to collectively occupy an area of at least 20 square millimeters, allowing the electronic control unit, via the guide holes, to maintain a guided flow rate of 77.8 milliliters / minute when tilted 30 degrees in the direction in which the opening is opened.

Preferably, the area on the base plate where the guide holes are provided is recessed in a stepped or graduated manner by a depth of 0.3 to 0.5 millimeters relative to other flat areas of the base plate.

Preferably, the ECU comprises an insulated body divided into at least one connection port, of which the insulated body is configured with an upper edge upwardly protruding from the top wall facing the housing and side edges protruding separately towards the side walls of the housing, with the upper edge and side edges being connected to form a frame around the insulated body, and a sealing component is positioned between the frame of the insulated body and the opening of the housing.

Preferably, the ECU further comprises a plurality of conductive terminals accommodated within respective connection ports, with the terminal pins of the conductive terminals extending downwardly through the printed circuit board to electrically connect the electrical connector with the printed circuit board.

Preferably, the ECU is an ECU for airbags in vehicles.

### Description of Accompanying Drawings

Further descriptions are provided below, with reference to the accompanying drawings, to enable a more thorough understanding and appreciation of the above and other aspects of the present disclosure, wherein:
FIG. 1 shows a schematic diagram of the IPX52 waterproof test of an ECU;
FIG. 2A shows a perspective view of the ECU according to a preferred example of the present disclosure;
FIG. 2B shows an exploded schematic diagram of the ECU according to a preferred example of the present disclosure;
FIG. 3 shows a sectional perspective view of the ECU according to a preferred example of the present disclosure, obtained along the YZ plane in FIG. 2A;
FIG. 4 shows, in order from left to right, a top view, a side view and a bottom view of the ECU according to a preferred example of the present disclosure;
FIG. 5 shows a planar schematic diagram of the shape of the guide holes provided in the ECU according to a preferred example of the present disclosure;

### Description of reference numerals

- 1: ECU
- 10: Base plate
- 20: Housing
- 30: Printed circuit board
- 40: Electrical connector
- 101: Load-bearing area
- 102: Mounting area
- 103: Guide hole
- 1011: Rib
- 1012: Mounting boss
- 1013: Mounting hole
- 1014: Reinforcing element
- 1021: Positioning recess
- 1022: Bracket mounting hole
- 1023: First protruding edge
- 1024: Second protruding edge
- 123: Fastener
- 201: Top wall
- 202: Side wall
- 203: Opening
- 21: Protruding eave
- 22a: First shielding portion
- 22b: Second shielding portion
- 401: Insulated body
- 402: Conductive terminal
- 403: Connection port
- 4011: Upper edge
- 4012: Side edge

### Specific Embodiments

To make the technical problem to be addressed, the technical solution, and beneficial technical effects of the present disclosure clearer and more understandable, the present disclosure is further described in detail below with reference to the accompanying drawings and exemplary examples. It should be understood that the specific examples described herein are provided solely for the purpose of explaining the present disclosure and not for limiting the scope of protection of the present disclosure.

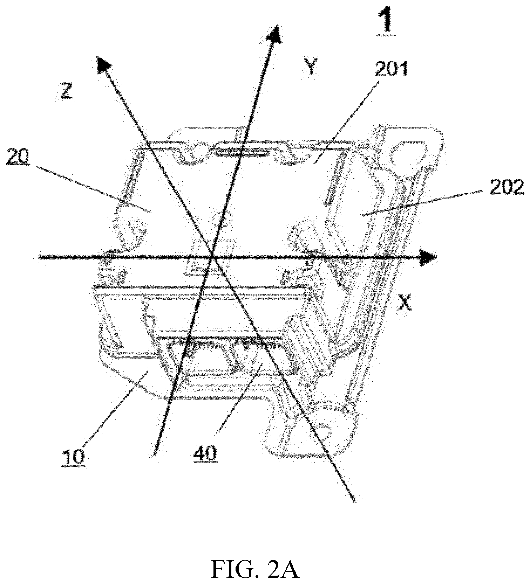

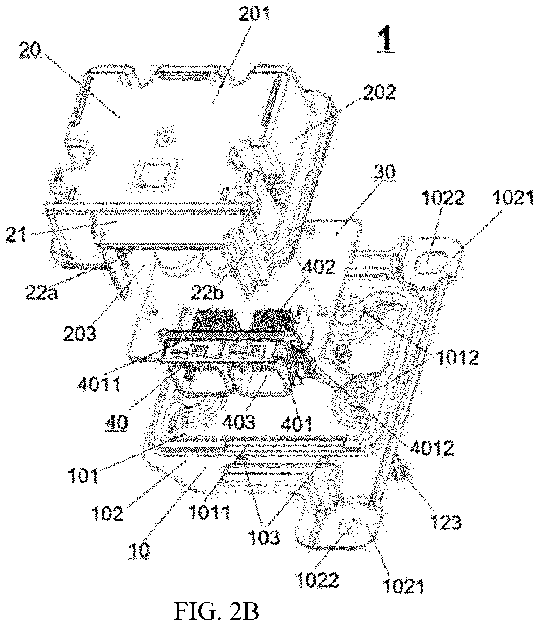

Referring to FIG. 2A and FIG. 2B, the perspective view and exploded schematic diagram of the assembled ECU according to a preferred example of the present disclosure are shown; In this example, using the example of a safety airbag ECU used in vehicles for explanation and illustration, those skilled in the art will understand that the relevant technical solutions are also applicable to other ECUs with similar waterproof requirements. The mounting orientation of the ECU is shown in the three-dimensional coordinate system in FIG. 2A, with the X-axis representing the transverse direction of the vehicle and the Y-axis representing the longitudinal direction of the vehicle, wherein the positive direction of the Y-axis represents the normal driving direction, and the Z-axis perpendicular to the XY plane represents the vertical direction of the vehicle. Specifically, the ECU 1 comprises a base plate 10, a housing 20 mounted on the base plate 10, a printed circuit board 30 provided between the base plate 10 and the housing 20, and an electrical connector 40 that is electrically connected to the printed circuit board 30 for connection and communication with an external device (not shown in the figure). In examples of the present disclosure, the housing 20 is formed by an injection molding process utilizing a plastic material, while the base plate 10 may be made of cold-rolled carbon structural steel (e.g., B280VK) or cold-rolled low-carbon steel plate (e.g., DC01). The floor 10 of the present disclosure may also be made of other metal materials, including alloy steels, by integral stamping. The housing 20 is a box-like structure, wherein the housing 20 comprises a top wall 201 and side walls 202 extending generally vertically downward from the edge of the top wall 201 and continuously disposed around the top wall 201. The top wall 201 and the side walls 202 are enclosed to form an accommodating space for the housing 20, and the printed circuit board 30 and the electronic components arranged thereon are accommodated in the accommodating space so that the housing 20 can protect the printed circuit board 30. The housing 20 is injection molded from a plastic, such as glass fiber-reinforced polypropylene, allowing the housing 20 to deform and absorb the energy generated by external impacts.

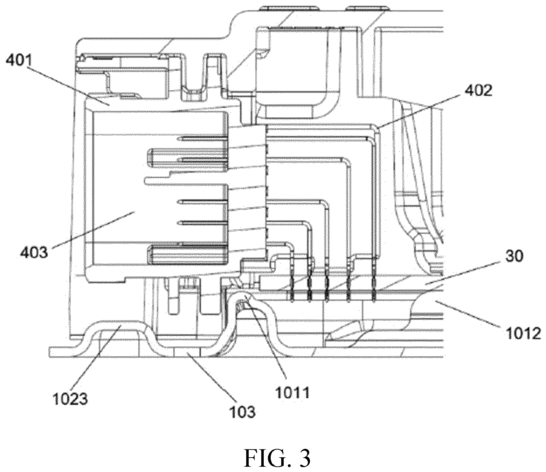

The printed circuit board 30 is a flat device, and it includes electronic components mounted thereon that control the operation of the airbags. Referring to FIG. 2B, the printed circuit board 30 is connected to the electrical connector 40. The electrical connector 40 includes an insulated body 401 and a plurality of conductive terminals 402, of which the insulated body 401 is an integral component made of synthetic resin such as PBT plastic (polybutylene terephthalate, thermoplastic polyester) that is divided into several connection ports 403 according to the object to which it is to be connected. In the illustrated example, the insulated body 401 comprises two connectors 403 provided side-by-side that are each connected to an external device. Those skilled in the art will understand that a greater or lesser number of connection ports may be provided according to actual needs. Correspondingly, the housing 20 has an opening 203 on one of the side walls that is connected to the above accommodating space in the insertion direction (i.e., the positive Y-axis direction), and the two connections 403 are oriented towards the outside of the housing 20 through the opening 203 and are connected to external devices by means of a wire harness. In other words, the electrical connector is exposed through the opening 203 provided on one of the side walls. Taking the mounting orientation shown in FIG. 2A and FIG. 2B as an example, the side wall configured with the opening extends along the transverse direction of the vehicle. On the other hand, as shown in conjunction with a partial sectional perspective view obtained along the YZ plane of the ECU of FIG. 3, the electrical connector 40 has a plurality of conductive terminals 402 accommodated within the two connection ports 403, and these conductive terminals 402 are electrically connected to the wiring circuit pattern on the printed circuit board 30. The electrical connector 40 is secured to the printed circuit board 30 by the terminal pins of the plurality of conductive terminals 402 extending downward through holes provided in the printed circuit board 30. Additionally, the electrical connector 40 may be secured to the printed circuit board 30 by the use of fasteners such as small screws.

FIG. 2B shows an exploded perspective view of the ECU according to FIG. 2A. As can be seen from the figure, the base plate 10, housing 20, and printed circuit board 30 are secured together by means of fasteners 123 (e.g., screws or studs). In the assembled state, the printed circuit board 30, together with the electrical connector 40 electrically connected thereto, is accommodated in the above accommodating space between the base plate 10 and the housing 20, wherein the electrical connector 40 is exposed via the opening 203 of the housing 20 to facilitate further electrical connections with external devices such as sensors, actuators, etc. As can be seen from the figure, there are four mounting holes provided separately on the base plate 10, the housing 20, and the printed circuit board 30 through which the fasteners pass, wherein a recessed portion that is recessed toward the accommodating space is correspondingly provided on the side wall 202 of the housing 20 to facilitate the provision of the above mounting holes at the bottom thereof. It is conceivable that the number of mounting holes is not limited to four, and that the positions at which they are set can be modified according to actual needs, as long as they are able to securely fasten the above components.

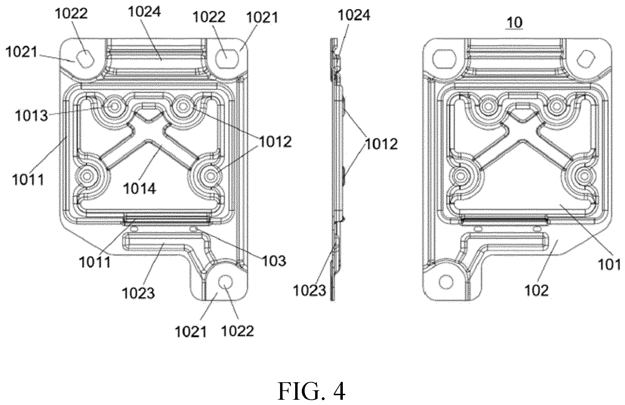

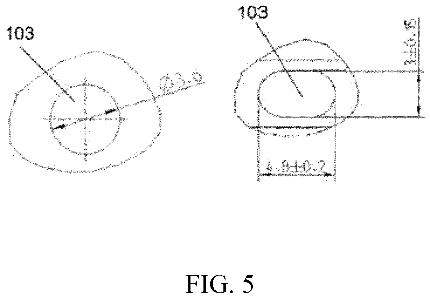

Referring further to FIG. 4, it shows, in order from left to right, a top view, a side view and a bottom view of the ECU 1 in FIG. 2B; The base plate 10 comprises a load-bearing area 101 and a mounting area 102. The load-bearing area 101 is substantially rectangular in shape. The mounting area 102 extends along the transverse direction of the vehicle on the side of the load-bearing area 101, and in this example, the mounting area 102 is separately provided on the side of the load-bearing area 101 proximate to the electrical connector 40 and on the opposite side thereof. Wherein, on the side of the mounting area proximate to the electrical connector, particularly in the region of the mounting area located below the electrical connector 40, guide holes 103 penetrating the base plate 10 are additionally provided. The guide holes 103 are used to drain accumulated water that may gather at the base plate. In the present disclosure, the shape, number, and positions of the guide holes 103 may be flexibly configured while meeting the above waterproof testing standards. For example, in the case of a water flow rate of 77.8 milliliters / minute (i.e., 350 milliliters of liquid spilled within 4.5 minutes), it needs to be ensured that the total area occupied by the guide holes 103 is at least greater than 20 square millimeters. Taking the shape of the guide hole shown in FIG. 5 as an example, two circular holes having a diameter greater than 3.6 millimeters may be provided in the corresponding mounting area. Alternatively, the shape of the guide holes may also be configured as elongated ovals. Considering the manufacturing process, the groove dimensions of the above elongated oval guide holes may be configured to be greater than 3 by 4 millimeters or 2 by 5.4 millimeters. Preferably, when configuring two elongated oval guide holes, a groove size of 3 by 4.8 millimeters may be adopted, and in this case, the total area occupied by the guide holes would be at least 25 square millimeters. As can be seen in conjunction with FIG. 2B and FIG. 4, when a plurality of guide holes 103 (e.g., two or more) are provided, the distance between the two farthest guide holes need to match the width of the electrical connector 40 in the transverse direction of the vehicle (e.g., in the illustrated example where the electrical connector has two connection ports, the distance between the farthest two guide holes is approximately 36 millimeters). That is to say, in order to enhance the waterproof performance where the electrical connector is located, all the guide holes need to be provided in the area corresponding to the electrical connector to ensure that the water flow does not accumulate along its flow path. From the sectional perspective view of FIG. 3, it can be seen that in the assembled state, the guide holes 103 are substantially positioned directly below the electrical connector 40.

Further, the load-bearing area 101 comprises a rib 1011, a plurality of mounting bosses 1012, and a plurality of mounting holes 1013. The rib 1011 is provided to enclose the load-bearing area 101 and protrude in a plane perpendicular to the load-bearing area, i.e., protrude towards the printed circuit board 30 in the assembled state. Preferably, the inner peripheral profile of the lower portion of the side walls 202 of the housing 20 matches the outer peripheral profile of the rib 1011, such that the side walls 202 of the housing 20 encloses the rib 1011 in a clearance-fitting manner in the assembled state. It is conceivable to those skilled in the art that the inner periphery of the housing's side wall may be in contact with the outer periphery of the rib at some points, while having a gap (e.g., 0.15 to 0.45 mm) from it at other parts; or that a sealing element may be provided between the inner periphery of the housing's side wall and the outer periphery of the rib to achieve a comprehensive seal between the housing and the aforementioned rib. By disposing the rib 1011 around the load-bearing area 101,water that may accumulate on the base plate 10 can be discharged from around the load-bearing area 101 along the rib 1011, thereby preventing the water from entering the ECU 1 through the gap between the printed circuit board 30 and the base plate 10 through the rib 1011 and causing damage thereto. A plurality of mounting bosses 1012 are provided in the area surrounded by the rib 1011 and protrude in the same direction as the protrusion of the rib 1011. The technical effect of providing the plurality of mounting bosses 1012 is that after the housing 20 and the printed circuit board 30 are mounted to the base plate 10, there is an even distribution of force on the housing 20 and the printed circuit board 30, preventing damage to the housing 20 and printed circuit board 30 due to uneven force. The above plurality of mounting bosses 1012 protrude a height of, for example, about 1 millimeter compared to other parts of the load-bearing area 101. Each of the plurality of mounting bosses 1012 is provided with a mounting hole 1013 at the top. The fasteners 123 pass through holes provided on the housing 20 and the printed circuit board 30, as well as corresponding mounting holes 1013 on the base plate 10, securing the base plate 10, the housing 20, and the printed circuit board 30 together. The technical effect of providing the rib 1011 and the plurality of mounting bosses 1012 and having them protrude in the same direction is that the rigidity and torsional strength of the load-bearing area 101 are enhanced, and that, after the housing 20 and the printed circuit board 30 are mounted to the base plate 10, the parts that actually come into contact with the housing 20 and the printed circuit board 30 are only the top of the rib 1011 and the tops of the plurality of mounting bosses 1012. In this way, the contact area of the base plate 10 with the housing 20 and the printed circuit board 30 is relatively small, reducing the impact on the housing 20 and the printed circuit board 30 when the vehicle generates vibrations. In the illustrated example, the load-bearing area 101 comprises four mounting bosses 1012 and four corresponding mounting holes 1013. It should be understood that the load-bearing area 101 may also comprise other numbers of mounting bosses and mounting holes as long as the mounting requirements can be met.

The mounting area 102 comprises a plurality of positioning recesses 1021, a plurality of bracket mounting holes 1022, a first protruding edge 1023, and a second protruding edge 1024. The positioning recesses 1021 are provided at the corners of the mounting area 102, and are recessed in the direction opposite to the protrusion of the rib 1011, with a depth of approximately 1 millimeter. In the illustrated example, three positioning recesses are shown, one of which is provided at one corner of the mounting area proximate to the side of the electrical connector, and the other two at two corners of the mounting area distal from the side of the electrical connector. Each positioning recess 1021 is separately provided with a bracket mounting hole 1022 at the bottom. The base plate 10 is secured to the vehicle via fasteners (not shown) that pass through the plurality of bracket mounting holes 1022. In the present example, for the airbag ECU, the base plate 10 is secured to the chassis, wherein mounting holes for fasteners to pass through are provided at corresponding positions on the chassis. It will be understood by those skilled in the art that, depending on the number of mounting holes in the corresponding part of the vehicle fixed with the base plate, corresponding positioning recesses may also be provided at all four corners of the mounting area. Additionally, depending on the positions of the mounting holes in the corresponding part of the vehicle fixed with the base plate, the above positioning recesses may also be provided at the edge of the mounting area. The technical effect of providing the plurality of positioning recesses 1021 and having them recessed in the direction opposite to the protrusion of the rib 1011 is that after the base plate 10 is mounted to the chassis, the part that is actually in contact with the chassis is only the plurality of positioning recesses of the base plate 10. In this way, the chassis has a relatively small contact area with the base plate 10, and the base plate 10 as a whole is about 1 mm higher compared to the mounting plane of the frame, minimizing the impact on the base plate 10 when the vehicle generates vibrations.

As shown in FIG. 4, the first protruding edge 1023 and second protruding edge 1024 separately extend transversely in the direction in which the opening 203 is opened in the mounting area on both sides of the load-bearing area, and preferably, the first protruding edge 1023 and the second protruding edge 1024 each extend to a corresponding positioning recess 1021. In this example, it can be observed that the first protruding edge 1023 extends transversely on the side of the mounting area proximate to the electrical connector, reaching the positioning recess 1021 located at the corner, while the second protruding edge 1024 extends transversely on the side of the mounting area distal from the electrical connector, between the corresponding two positioning recesses. The technical effect of providing the first protruding edge 1023 and the second protruding edge 1024 are that the rigidity and the torsional strength of the mounting area 102 are enhanced. In addition, as further illustrated in the figure, the first protruding edge 1023 extends in the transverse direction by a distance corresponding to the extension length of the electrical connector 40 in the transverse direction (i.e., in the direction transverse to the direction in which the opening 203 is opened), and in the case of a plurality of guide holes, it exceeds the distance between the two guide holes that are farthest apart, so as to enable the first protruding edge 1023, in addition to being able to enhance the rigidity and torsional strength of the mounting area 102, to provide a preliminary blocking effect against splashing water.

The assembly process of the ECU 1 of this example is next described. The housing 20 is formed by injection molding to create the above opening 203 and the accommodating space. The electrical connector 40 is electrically connected to the printed circuit board 30 via the conductive terminals 402, after which the printed circuit board 30 is assembled by extending from the underside of the housing 20 into the accommodating space. For example, the inner side walls of the housing 20 may be provided with grooves for engaging the printed circuit board 30, and the positions of the housing 20 and the printed circuit board 30 are relatively fixed after the printed circuit board 30 is inserted into the grooves. Next, the pre-assembled housing 20 and the printed circuit board 30, along with the electrically connected electrical connector 40, are placed in the load-bearing area 101 of the base plate 10, such that the mounting holes on the housing and the printed circuit board are aligned with the mounting holes on the mounting bosses in the load-bearing area of the base plate, and the housing 20, the printed circuit board 30 and the base plate 10 are then secured together by means of fasteners 123. Upon completion of assembly of the ECU 1, additional fasteners (not shown) are further used to pass through the bracket mounting holes 1022 in the positioning recesses 1021 of the base plate 10 to mount the assembled ECU to the vehicle component (e.g., chassis). A partial sectional structure of the assembled ECU 1 is shown in FIG. 3.

The waterproof principle of the ECU of the present disclosure is explained below in conjunction with FIG. 3. Referring to FIG. 3, it can be seen that a part of the rib 1011 (specifically, the part corresponding to the area between the base plate and the electrical connector) is raised compared to other parts of the rib, and in this example, the raise in height is approximately 1 millimeter. Accordingly, as previously noted, the plurality of mounting bosses 1012 of the load-bearing area protrude, for example, by a height of about 1 millimeter compared to other parts of the load-bearing area, so there is a gap of about 1 millimeter between the printed circuit board 30 and the areas of the base plate 10 other than the mounting bosses 1012 in the assembled state. If viewed along the longitudinal direction of the vehicle (i.e. along the direction in which the opening 203 is opened), the raised area of the rib 1011 is able to block the gap between the base plate 10 and the printed circuit board 30 to prevent the water flow from passing over the rib and entering the interior of the ECU via the above gap. In this scenario, the upwardly protruding first protruding edge 1023 and the rib 1011 provided on the base plate 10, and at the same time, guide holes 103 are also provided in the mounting area between the two to drain accumulated water. As shown in the figure, when the vehicle is going downhill, the ECU is susceptible to spills of liquids (e.g., beverages such as water or juice) from the cup holder. In the case of a relatively low flow rate, the water flow will be blocked by the first protruding edge 1023 provided on the base plate 10 and directed to areas on both sides of the base plate other than the mounting area. On the contrary, if the flow rate gradually increases with an increase in slope (e.g., at the maximum angle of 30 degrees in a waterproof test), the water flow will pass over the first protruding edge 1023 and further move towards the rib 1011 along the direction of travel (i.e., the positive Y-axis). At this point, since additional guide holes 103 are provided on the side of the mounting area proximate to the electrical connector, the accumulated water can preferentially flow out from the lower end of the base plate through the guide holes 103, while excess water flow will be further blocked by the rib 1011 and directed towards the two sides of the base plate outside the mounting area along the rib. It is to be noted that although the guide holes are provided on a relatively flat surface of the base plate in the illustrated example, the area on which the guide holes are provided on the base plate may also be recessed a certain depth (e.g., 0.3 - 0.5 millimeters) relative to other areas of the base plate, and the recess may be in the form of steps or a gradual transition. In this scenario, excessive water flow, after crossing over the first protruding edge, is more likely to flow towards the guide holes in the recessed area, facilitating the drainage of this part of the water flow and thereby enhancing the waterproof effect.

In addition to the waterproof structure above that prevents water flow from flowing into the ECU 1 via a gap between the base plate 10 and the printed circuit board 30, there is provided in the ECU 1 of the present disclosure a waterproof structure that prevents water flow from entering the ECU via a gap between the electrical connector 40 and the housing 20 and from splashing directly onto the electrical connector 40 from above. As shown in FIG. 2B, the electrical connector 40 has a frame around the connection ports 403 that is designed to abut against the housing 20 when the electrical connector 40 is mounted to the opening 203. Specifically, the insulated body 401 of the electrical connector 40 is provided with an upper edge 4011 protruding upwardly toward the top wall 201 of the housing and side edges 4012 protruding separately toward the side walls 202, and the upper edge 4011 and the side edges 4012 are connected to form a frame surrounding the insulated body 401. It should be understood that, in this embodiment, the upper edge 4011 and the side edges 4012 can form a frame around the insulated body 401 on one plane, while in other example, the upper edge 4011 and the side edges 4012 may also be formed on different planes. Preferably, the frame is equipped with one or a plurality of snap fasteners, and the inner side wall of the housing is provided with corresponding snap grooves. The frame of the electrical connector is inserted into the snap grooves, allowing the electrical connector to be relatively secured to the housing at the opening 203. To achieve a higher waterproof standard, a sealing component may be placed between the electrical connector 40 and the housing 20, particularly between the frame of the electrical connector and the opening 203 of the housing. The sealing member is made of a material such as rubber or thermoplastic elastomer. It is conceivable that the shape of the sealing member is adapted to the external profile of the frame of the electrical connector. This seals the gap between the frame of the electrical connector and the opening of the housing, preventing water from entering the ECU through the above gap. Additionally, the top wall 201 of the housing 20 has a protruding eave 21 that conceals the electrical connector when it is mounted to the opening, and the housing also has a first shielding portion 22a and a second shielding portion 22b that shields the electrical connector when it is mounted to the opening, with the protruding eave 21 separately connected to the first shielding portion 22a and the second shielding portion 22b; further, in the assembled state, the protruding eave 21, the first shielding portion 22a and the second shielding portion 22b, along with the side of the mounting area provided with guide holes on the base plate, collectively enclose the electrical connector exposed through the opening. In this scenario, because the electrical connector 40 is collectively enclosed by the protruding eave 21, the first shielding portion 22a, the second shielding portion 22b and the base plate 10, it can avoid being splashed directly from above by the water flow. Furthermore, as can be seen in conjunction with FIG. 2A and FIG. 2B, the first shielding portion 22a and the second shielding portion 22b extend further along the longitudinal direction of the vehicle (i.e., along the direction in which the opening 203 is opened) until the first protruding edge 1023 is enclosed in the direction transverse to the direction in which the opening 203 is opened. In this scenario, the water flow that may cross over the first protruding edge can be constrained to accumulate in the area with guide holes and be discharged through the guide holes, preventing it from flowing out from the two sides. Furthermore, the area where the guide holes 103 are provided is located below the electrical connector 40 and is further blocked in the transverse direction by the first shielding portion 22a and the second shielding portion 22b, as well as in the longitudinal direction by the first protruding edge 1023, so the guide holes penetrating through the base plate are not visibly observable from the outside, conforming more to aesthetic requirements.

Referring again to FIG. 4, additional descriptions are provided for the base plate structure of the ECU. As can be seen from the figure, in the preferred example of the present disclosure, the dimensions of the base plate 10 along the longitudinal direction of travel of the vehicle are different from those along the transverse direction of the vehicle, with the former larger compared to the latter. Accordingly, the spacing of the positioning recesses provided at the corners of the base plate mounting area is also greater along the direction of travel of the vehicle than along the transverse direction of the vehicle. This design is intended to accommodate the layout of mounting holes on a part of the vehicle (such as the chassis) to which the ECU is fixed. However, the present disclosure is not limited to the above. In other words, the spacing of the positioning recesses on the base plate along the longitudinal direction of travel of the vehicle can also be less than or equal to the spacing along the transverse direction of the vehicle. Where the two are equal, it may be approximated that the base plate is constructed in a square like manner, such that the ECU may be secured to the vehicle in two configurations. In the normal first configuration, the orientation of the connector wire harness of the ECU is parallel to the direction of travel of the vehicle, i.e., as shown in FIG. 2A of this application. In the second configuration, the connection orientation of the connector wire harness of the ECU can be perpendicular to the direction of travel of the vehicle, i.e., parallel to the transverse direction of the vehicle. In other words, compared to the first configuration shown in FIG. 2A, in the second configuration, the ECU is rotated 90 degrees either counterclockwise or clockwise as a whole. As the spacing of the positioning recesses on the base plate along the direction of travel of the vehicle is equal to the spacing along the transverse direction of the vehicle, a portion of the mounting holes on the chassis used for mounting the base plate in the first configuration may still be used for the base plate. In this way, it is possible to adapt the base plate to two mutually perpendicular mounting orientations by providing the same mounting holes on the chassis. In this way, the ECU may be mounted in different orientations according to the actual reserved space in the vehicle to adapt to the installation requirements of different OEM manufacturers. On the other hand, when the ECU is secured to the vehicle in the second configuration, the risk of the ECU being splashed by water may also be reduced because the connection orientation of the connector wire harness is parallel to the transverse direction of the vehicle, i.e., the direction of exposure of the electrical connector of the ECU along the transverse direction of the vehicle. This is because, during regular driving, the inclination of the vehicle in the transverse direction is much smaller than the slope when going uphill or downhill along the longitudinal direction. It is to be noted that for an ECU, for example, an airbag ECU, in the said second configuration mode, the above second configuration mode requires the layout and correction of the internal sensor components to be reset. Due to the low relevance of this to the purpose of enhancing the waterproof performance of the ECU as emphasized in this application, it is not extensively elaborated upon herein.

Additionally, as shown in FIG. 4, a reinforcing element 1014 is provided between the mounting bosses 1012 in the load-bearing area 101 of the base plate 10. The reinforcing element 1014 similarly protrudes upwards in the protrusion direction of the mounting bosses 1012 by 0.3 to 0.5 millimeters, i.e., not exceeding the protrusion height of the mounting bosses 1012 to avoid contact with the printed circuit board 30. By providing the above reinforcing element, the intrinsic frequency of the electronic control unit can be reduced to be staggered with the operating frequency of the sensor provided therein, thereby enhancing the accuracy and safety of the sensor. In the illustrated example, the reinforcing element 1014 is substantially arranged in an X shape. However, those skilled in the art will understand that the reinforcing element can be provided in any patterned shape in the load-bearing area of the base plate, as long as it can reduce the inherent frequency of the ECU and at the same time avoid contact with the printed circuit board.

In summary, for ECUs with special mounting hole requirements on the base plate (especially for ECUs with larger-scale base plates beneath the electrical connector), the adoption of the technical solution of the present disclosure can effectively prevent the intrusion of water into the interior of the ECU. Moreover, compared to conventional solutions in the field that reinforce ECU sealing, the proposed solution can significantly reduce costs. Additionally, the provision of protruding edges on the base plate of the ECU of the present disclosure can effectively enhance the strength of the base plate, avoiding potential strength reduction issues that may arise from punching holes.

Feasible but non-limiting embodiments of the ECU according to the present disclosure have been described in detail above with reference to the accompanying drawings. Those skilled in the art would understand that modifications and supplements to the technology and structure, as well as recombination of features in the various examples, are considered to be within the scope of the present disclosure, as defined by the claims set forth below, without departing from the scope and essence of the present disclosure. Therefore, such modifications and supplements that may be conceived under the guidance of the present disclosure shall be considered as part of the present disclosure. The scope of the present disclosure is defined by the appended claims and comprises equivalent technologies known at the time of filing of the present disclosure, as well as unforeseen equivalent technologies.

## Claims

1. An electronic control unit (1), comprising
a base plate (10) comprising a load-bearing area (101) and a mounting area (102) provided on a side of the load-bearing area (101), with at least one guide hole (103) penetrating the base plate (10) provided in the mounting area (102);
a housing (20) mounted on the load-bearing area (101) of the base plate (10) comprising a top wall (201) and side walls (202) extending downwardly from the edge of the top wall (201) and disposed continuously around the top wall (201), wherein the top wall (201) and the side walls (202) collectively define an accommodating space of the housing (20);
a printed circuit board (30), this printed circuit board (30) is housed in the accommodating space between the base plate (10) and the housing (20); and
an electrical connector (40) electrically connected with the printed circuit board (30), which is exposed through an opening (203) provided on one of the side walls and is positioned above the guide holes (103).

2. The electronic control unit (1) according to Claim 1, wherein the base plate (10) is an integral stamped piece made of a metal material, the load-bearing area (101) is provided with a rib (1011) configured to enclose the load-bearing area (101) and protrude towards the printed circuit board (30) in a plane perpendicular to the load-bearing area (101).

3. The electronic control unit (1) according to Claim 2, wherein the inner peripheral profile of the lower portion of the side walls (202) matches the outer peripheral profile of the rib (1011), such that the side walls (202) of the housing (20) encloses the rib (1011) in a clearance-fitting manner in the assembled state.

4. The electronic control unit (1) according to Claim 3, wherein the load-bearing area (101) further comprises a plurality of mounting bosses (1012) provided in the area enclosed by the rib (1011) and protruding in the same protrusion direction as the rib (1011), such that a gap is created between the printed circuit board (30) and the base plate (10) in the assembled state.

5. The electronic control unit (1) according to Claim 4, wherein a part of the rib (1011) positioned between the electrical connector (40) and the base plate (10) is raised as compared to other parts of the rib (1011), such that viewing that part of the rib in the direction in which the opening (203) is opened obscures the gap between the printed circuit board (30) and the base plate (10).

6. The electronic control unit (1) according to any of Claims 4 or 5, wherein mounting holes (1013) are provided at the top of each mounting boss (1012), and wherein with the aid of fasteners (123) passing through the mounting holes (1013) and through corresponding mounting holes provided in the housing (20) and in the printed circuit board (30), the base plate (10), the housing (20) and the printed circuit board (30) are secured together, wherein a reinforcing element (1014) is provided between the mounting bosses (1012) in the load-bearing area (101), of which the reinforcing element (1014) protrudes in the same protrusion direction as the mounting bosses (1012) and has a protrusion height smaller than the protrusion height of the mounting bosses (1012).

7. An electronic control unit (1) according to any one of Claims 2 to 5, wherein in the assembled state, the housing (20) has a protruding eave (21) that covers the electrical connector (40), as well as a first shielding portion (22a) and a second shielding portion (22b), with the protruding eave (21) connecting the first shielding portion (22a) and the second shielding portion (22b); on the side of the mounting area (102) distal from the electrical connector (40), a first protruding edge (1023) is provided extending transversely to the direction in which the opening (203) is opened; the guide holes (103) are positioned between the rib (1011) and the first protruding edge (1023) in the direction in which the opening (203) is opened; the distance of the first protruding edge (1023) extending transversely corresponds to the length of the electrical connector (40) in the direction transverse to the direction in which the opening (203) is opened, with the distance being greater than the distance between the two furthest guide holes (103) from each other; additionally
in the assembled state, the protruding eave (21), the first shielding portion (22a) and the second shielding portion (22b), along with the mounting area (102) on the side of the base plate (10) where guide holes (103) are positioned, collectively enclose the electrical connector (40) exposed from the opening (203).

8. The electronic control unit (1) according to Claim 7, wherein the first shielding portion (22a) and the second shielding portion (22b) extend in the direction in which the opening (203) is opened until the first protruding edge (1023) is enclosed in the direction transverse to the direction in which the opening (203) is opened.

9. The electronic control unit (1) according to Claim 7, wherein the mounting area (102) further comprises a plurality of positioning recesses (1021), a bracket mounting hole (1022) provided at the bottom of each positioning recess (1021), and a second protruding edge (1024), which extends in the direction transverse to the direction in which the opening (203) is opened on the side of the mounting area (102) distal from the electrical connector (40), and the plurality of positioning recesses (1021) extend separately from the first protruding edge (1023) and the second protruding edge (1024) towards the edges or corners of the corresponding mounting area (102).

10. The electronic control unit (1) according to Claim 9, one of the positioning recess extends transversely, on the side of the mounting area proximate to the electrical connector (40), from the first protruding edge (1023) to the corner of the mounting area, and two positioning recesses extend separately, on the side of the mounting area distal from the electrical connector (40), from the second protruding edge (1024) to the two corners of the mounting area.

11. The electronic control unit (1) according to any of Claims 1 to 5, wherein the guide holes (103) are configured to collectively occupy an area of at least 20 square millimeters, allowing the electronic control unit (1), via the guide holes, to maintain a guided flow rate of 77.8 milliliters / minute when tilted 30 degrees in the direction in which the opening (203) is opened.

12. The electronic control unit (1) according to any of Claims 1 - 5, wherein the area on the base plate (10) where the guide holes (103) are provided is recessed in a stepped or graduated manner by a depth of 0.3 to 0.5 millimeters relative to other flat areas of the base plate (10).

13. The electronic control unit (1) according to any of Claims 1 to 5, wherein the electrical connector (40) comprises an insulated body (401) divided into at least one connection port (403), of which the insulated body (401) is configured with an upper edge (4011) upwardly protruding from the top wall (201) facing the housing (20) and side edges (4012) protruding separately towards the side walls of the housing (20), with the upper edge (4011) and side edges (4012) being connected to form a frame around the insulated body (401), and a sealing component is positioned between the frame of the insulated body (401) and the opening (203) of the housing (20).

14. The electronic control unit (1) according to Claim 13, wherein the electrical connector (40) further comprises a plurality of conductive terminals (402) accommodated within respective connection ports (403), with the terminal pins of the conductive terminals (402) extending downwardly through the printed circuit board (30) to electrically connect the electrical connector (40) with the printed circuit board (30).

15. The electronic control unit (1) according to any of Claims 1 to 5, which is an electronic control unit for airbags in vehicles.
